# EUROPEAN PATENT APPLICATION

(11) **EP 2 337 217 A2**
(43) Date of publication of application: **22.06.2011**
(21) Application number: 10192281.3
(22) Date of filing: 23.11.2010
(51) Int. Cl.: H03D 7/18

(54) **Harmonic rejection mixer and radio frequency receiver using the mixer**

(30) Priority: 09.12.2009 KR 20090121906
(71) Applicant: SAMSUNG ELECTRONICS CO., LTD., Suwon-si, Gyeonggi-do (KR)
(72) Inventor: Cho, Seung-woo, Gyeonggi-do (KR); Ryu, Jae-young, Gyeonggi-do (KR); Kim, Jong-jin, Gyeonggi-do (KR); Kang, Hyun-koo, Gyeonggi-do (KR); Ku, Yeon-woo, Gyeonggi-do (KR); Lee, Jeong-su, Gyeonggi-do (KR)
(74) Representative: Hewett, Jonathan Michael Richard

(57) **Abstract**

A mixer used in a Radio Frequency (RF) receiver is provided. The mixer includes a first harmonic rejecter for rejecting a harmonic signal component from a first input signal; and a second harmonic rejecter for rejecting a harmonic signal component from a second input signal. The first harmonic rejecter and the second harmonic rejecter are connected in parallel to reject an image signal component from the first input signal and the second input signal. Thus, the RF receiver can reject the harmonic signal and the image signal without using an external element.

## Description

The present invention relates to a mixer and a Radio Frequency (RF) receiver using the mixer. More specifically, the present invention relates to a mixer for rejecting a harmonic signal and an image signal at the same time without using an external element, and an RF receiver using the mixer.

In general, a wideband Radio Frequency (RF) receiver receives and processes an RF signal of the wideband.

Unlike a narrow-band RF receiver, the wideband RF receiver receives not only a signal of the intended channel but also signals of the unwanted channels. As a result, technical problems such as the inclusion of harmonic signals, image signals, and linearity problems occur.

To address the problem of harmonic signals and the image signals being received by the wideband receivers, a double conversion scheme using an external Surface Acoustic Wave (SAW) filter is mainly adopted. However, since the double conversion scheme requires a chip external element such as the SAW filter, it is not suited for the integration trend to Radio Frequency Interface Chip (RFIC) or System-on-a-chip (SoC).

Exemplary embodiments of the present invention provide a mixer for concurrently rejecting a harmonic signal and an image signal at a mixer stage without using an external element, and an RF receiver using the mixer.

According to an aspect of the present invention, a mixer includes a first harmonic rejecter for rejecting a harmonic signal component from a first input signal; and a second harmonic rejecter for rejecting a harmonic signal component from a second input signal. The first harmonic rejecter and the second harmonic rejecter may be connected in parallel to reject an image signal component from the first input signal and the second input signal.

At least one of the first and second harmonic rejecters may be implemented using a harmonic rejection mixer which rejects the harmonic signal component from the first input signal or the second input signal by mixing a plurality of local oscillation signals having a phase difference with the input signal.

The harmonic rejection mixer may be in a single quadrature structure comprising two harmonic rejection mixers of a double balanced structure.

At least one of the first and second harmonic rejecters may be implemented using a harmonic rejection filter which filters the harmonic signal component in the input signal, and a mixer which frequency-converts the filtered signal.

The first harmonic rejecter may receive an in-phase signal, the second harmonic rejecter may receive a quadrature phase signal, and outputs of the first and second harmonic rejecters may be connected in parallel.

According to another aspect of the present invention, an RF receiver includes a first filter for filtering an input signal; and a mixer comprising a plurality of harmonic rejecters connected in parallel for rejecting a harmonic signal of the filtered signal, and for rejecting an image signal component.

The mixer may include a first harmonic rejecter and a second harmonic rejecter connected to the first harmonic rejecter in parallel.

The RF receiver may further include a local oscillator for generating a plurality of local oscillation signals having a phase difference. At least one of the first and second harmonic rejecters may be implemented using a harmonic rejection mixer which rejects the harmonic signal component by mixing the plurality of the local oscillation signals having the phase difference with the filtered signal.

The harmonic rejection mixer may be in a single quadrature structure comprising two harmonic rejection mixers of a double balanced structure.

At least one of the first and second harmonic rejecters may be implemented using a harmonic rejection filter for filtering the harmonic signal, and a mixer for frequency-converting the filtered signal.

The first filter may be implemented using a polyphase filter which generates an in-phase signal and a quadrature phase signal with respect to the input signal.

The RF receiver may further include a second filter disposed at a rear end of the mixer and filtering the image signal component.

The second filter may be implemented using a complex filter.

The second filter may be implemented using a polyphase filter.

The first harmonic rejecter may receive an in-phase signal, the second harmonic rejecter may receive a quadrature phase signal, and outputs of the first and second harmonic rejecters may be connected in parallel.

As set forth above, the wideband RF receiver can reject the harmonic signal and image signal components at the same time without using an external element such as SAW filter. Therefore, in the current trend toward the integration to the RFIC or the SoC, the full integration wideband RF receiver excluding the use of the external element can be realized.

The above and/or other aspects of the exemplary embodiments will become more apparent by describing certain exemplary embodiments with reference to the accompanying drawings, in which:
FIG. 1 is a diagram of a mixer structure according to an exemplary embodiment;
FIGS. 2A and 2B are diagrams of a concrete implementation of a harmonic rejecter according to various exemplary embodiments;
FIGS. 3A and 3B are diagrams of a harmonic signal rejection process of the harmonic rejecter of FIGS. 2A and 2B;
FIG. 4 is a diagram of an image rejection process of a mixer 100 of FIG. 1;
FIG. 5 is a block diagram of an RF receiver according to an exemplary embodiment;
FIG. 6 is a detailed circuit diagram of the mixer 100 according to an exemplary embodiment;
FIG. 7A is a diagram of a wave form of a local oscillation signal input to the mixer 100;
FIG. 7B is a circuit diagram of a harmonic rejection mixer according to an exemplary embodiment; and
FIGS. 8A through 8E are diagrams of a signal form in each step of the structures of
FIG. 5 and FIG. 6.

Exemplary embodiments are described in greater detail below with reference to the accompanying drawings.

In the following description, like drawing reference numerals are used for the like elements, even in different drawings. The matters defined in the description, such as detailed construction and elements, are provided to assist in a comprehensive understanding of the exemplary embodiments. However, the exemplary embodiments can be practiced without those specifically defined matters. Also, well-known functions or constructions are not described in detail since they would obscure the exemplary embodiments with unnecessary detail.

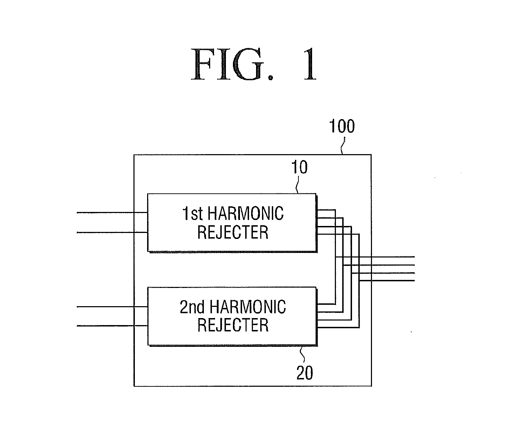

FIG. 1 illustrates a mixer structure according to an exemplary embodiment.

Preferably, the mixer 100 of FIG. 1 can be applied to a wideband RF receiver which receives and processes a broadcast signal of the wideband.

Referring to FIG. 1, the mixer 100 can include two harmonic rejecters 10 and 20 connected in parallel. Herein, the parallel connection specifies that the outputs of the two harmonic rejecters 10 and 20 are connected in parallel.

The first harmonic rejecter 10 and the second harmonic rejecter 20 each reject the harmonic signal component from their input signal. Herein, the harmonic signal is a multiplying frequency signal of the fundamental frequency signal (e.g., the signal component of the frequencies 2f₀ 3f₀, ... when the fundamental frequency signal is f₀). The harmonic signal becomes the unwanted signal of a designer; that is, a noise component.

Herein, the first and second harmonic rejecters 10 and 20 can be implemented using harmonic rejection mixers or the combination of a harmonic rejection filter and a general mixer.

The mixer 100 is the parallel connection of the first and second harmonic rejecters 10 and 20 which are implemented using the harmonic rejection mixers or the combination of the harmonic rejection filter and the mixer.

By connecting the first and second harmonic rejecters 10 and 20 in parallel as above, it is possible to carry out image rejection for rejecting the image signal component of the wanted channel. For example, by dividing the RF signal to the positive (+) frequency band and the image signal to the negative (-) frequency band, the RF signal and the image signal component are prevented from existing in the positive frequency band or in the negative frequency band at the same time. The image signal (or the image frequency) component indicates a symmetric frequency component of the received signal in terms of the frequency based on the local oscillation frequency at the RF receiver.

Now, a concrete implementation of the harmonic rejecters 10 and 20 is described.

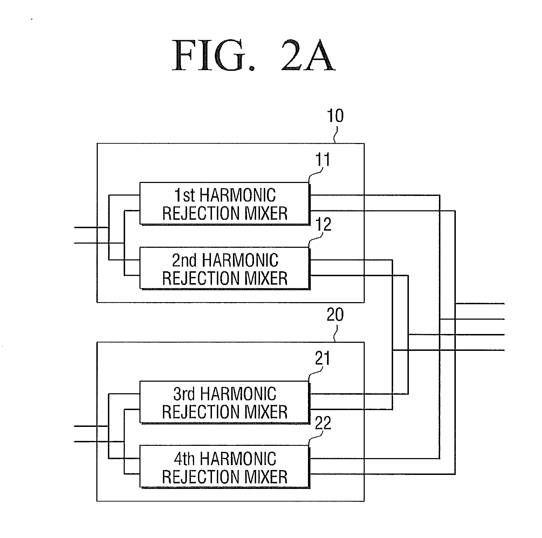

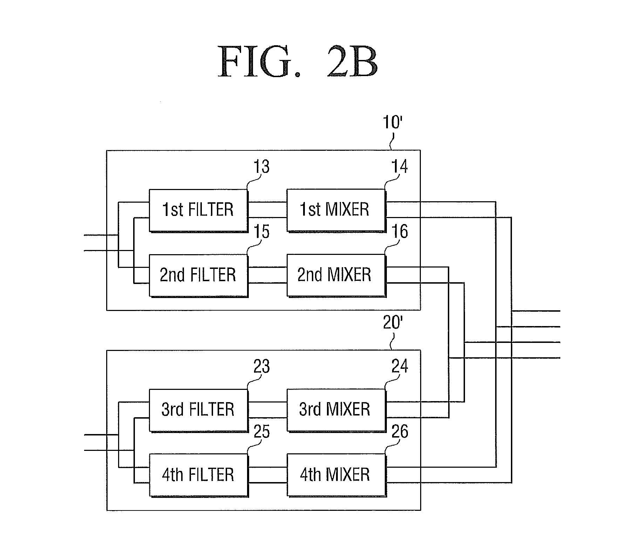

FIGS. 2A and 2B depict concrete implementations of the harmonic rejecter according to various exemplary embodiments.

Referring to FIG. 2A, the first harmonic rejecter 10 includes a first harmonic rejection mixer 11 and a second harmonic rejection mixer 12, and the second harmonic rejecter 20 includes a third harmonic rejection mixer 21 and a fourth harmonic rejection mixer 22.

The first through fourth harmonic rejection mixers 11, 12, 21 and 22 each can be implemented using a double balanced structure which receives the RF+ and RF-signals and generates the IF+ and IF- signals.

The first through fourth harmonic rejection mixers 11, 12, 21 and 22 can include a plurality of transistors which are turned on or off in response to a local oscillation signal LO. The transistors are turned on or off in sequence by receiving a plurality of local oscillation signals LO having the phase difference, and provide the local oscillation signal of the sine wave. Thus, the harmonic signal component in the RF signal can be rejected.

Meanwhile, the first harmonic rejecter 10 and the second harmonic rejecter 20 can be of a single quadrature structure which receives two RF signals and outputs four Intermediate Frequency (IF) signals. That is, by implementing the first and second harmonic rejection mixers 11 and 12 constituting the first harmonic rejecter 10 in the double balanced structure, the first harmonic rejecter 10 outputs four IF signals in the end.

The mixer 100 receives the four RF signals in total including the two RF signals each received at the first harmonic rejecter 10 and the second harmonic rejecter 20, outputs two IF signals by adding the outputs of the first harmonic rejection mixer 11 and the fourth harmonic rejection mixer 22, and outputs two IF signals by adding the outputs of the second harmonic rejecter mixer 12 and the third harmonic rejection mixer 21. Hence, the mixer 100 can be of the double quadrature structure which receives the four RF signals and outputs the four IF signals.

FIG. 2B depicts the detailed structure of the harmonic rejecter according to another exemplary embodiment.

Referring to FIG. 2B, the first harmonic rejecter 10' includes a first filter 13, a first mixer 14, a second filter 15, and a second mixer 16, and the second harmonic rejecter 20' includes a third filter 23, a third mixer 24, a fourth filter 25, and a fourth mixer 26.

The first through fourth filters 13, 15, 23 and 25 can be implemented using harmonic rejection filters which reject the harmonic signal component in the input signal. More specifically, the first through fourth filters 13, 15, 23 and 25 can be implemented using Low-Pass Filters (LPFs), High-Pass Filters (HPFs), and BandPass Filters (BPFs) for the frequency filtering. By passing only the band around the intended channel and rejecting the other signals, the noise source caused by the harmonic signal can be removed in advance. That is, it is possible to reject the RF signal harmonic component corresponding to the harmonic signal band of the local oscillation frequency.

In some cases, the first through fourth filters 13, 15, 23 and 25 can be implemented using a single filter which combines the harmonic rejection filter for rejecting the harmonic signal component and an Image Rejection Filter (IRF) for rejecting the image signal component.

The first through fourth mixers 14, 16, 24 and 26 function to generate the IF signal by mixing the RF signal free from the harmonic signal component by the first through fourth filters 13, 15, 23 and 25 with the LO signal of a local oscillator (not shown).

Herein, the first through fourth mixers 14, 16, 24 and 26 can be implemented using a double balanced mixer which receives and mixes two signals RF+ and RF- with the local oscillation signal LO and outputs two signals IF+ and IF-. The double balanced mixer performs the mixing using a double balanced scheme, which shall be omitted here for brevity. The first through fourth mixers 14, 16, 24 and 26 can be implemented, for example, using a Gilbert cell mixer (or Gilbert mixer). This is a mere example of the mixer, and any mixer capable of down-converting the RF signal to the IF signal can be employed.

As stated above, the combinations of the first through fourth filters 13, 15, 23 and 25 and the first through fourth mixers 14, 16, 24 and 26 reject the harmonic signal component, and function to down-convert the RF signal to the IF signal.

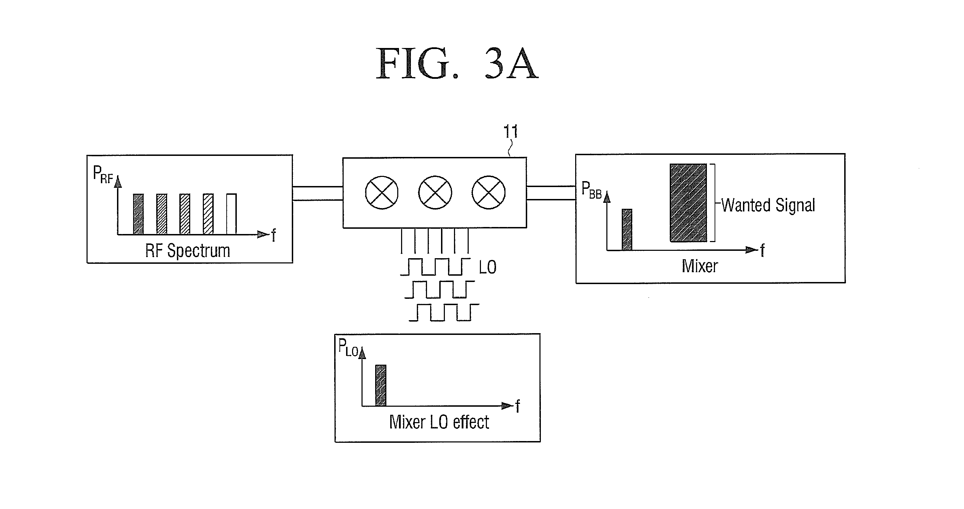

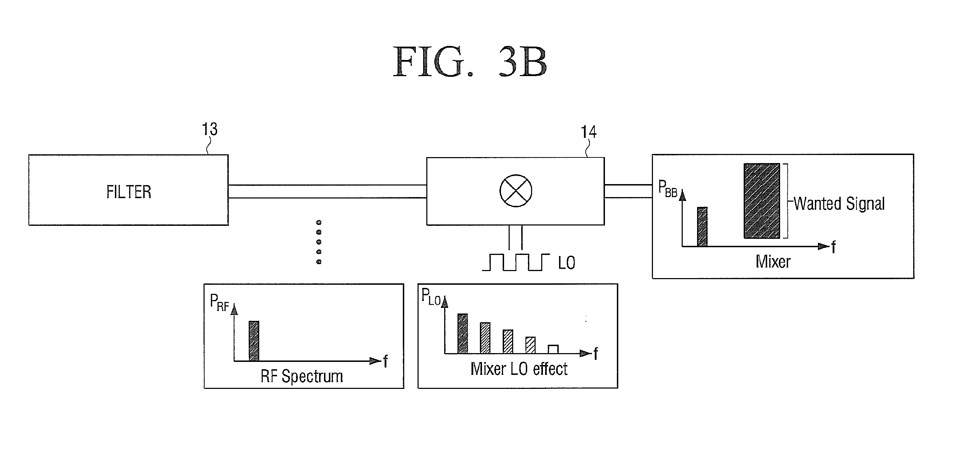

FIGS. 3A and 3B depict a harmonic signal rejection process of the harmonic rejecters of FIGS. 2A and 2B.

FIG. 3A shows the harmonic signal rejection process of the harmonic rejecter of FIG. 2A.

In FIG. 3A, the harmonic rejection mixer 11 rejects the harmonic signal. Six local oscillation signals LO having the phase difference are fed to three local mixers of the harmonic rejection mixer 11, the harmonic signal component of the RF signal is removed, and the down-converted IF signal is yielded.

In FIG. 3B, the harmonic rejection filter 13 and the general mixer 14 remove the harmonic signal. The harmonic rejection filter 13 filters the harmonic signal component of the RF signal and outputs the filtered RF signal to the mixer 14 to thus produce the down-converted IF signal.

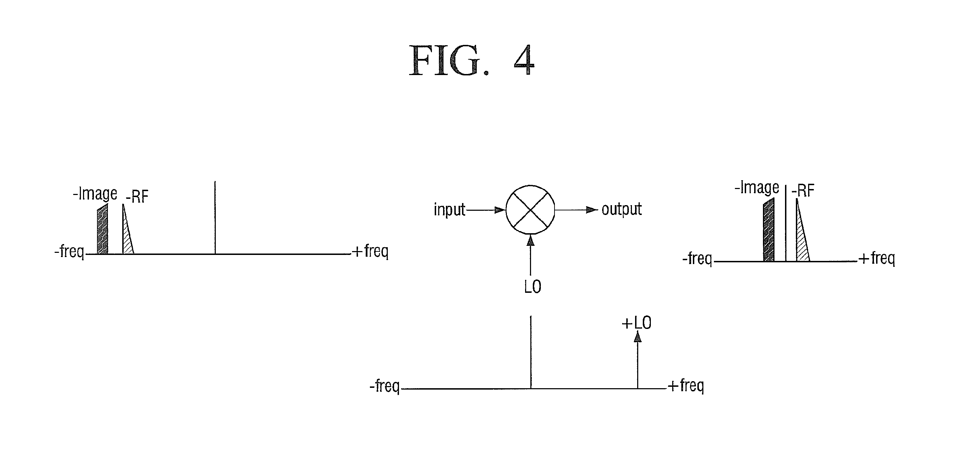

FIG. 4 depicts an image rejection process of the mixer 100 of FIG. 1.

In the mixer 100 of FIG. 1, the first harmonic rejecter 10 and the second harmonic rejecter 20 each implemented using the harmonic rejection mixers or the combination of the harmonic rejection filter and the mixer, are connected in parallel and have the image rejection function for rejecting the image signal component.

As shown in FIG. 4, the mixer 100 can mix the signal including the RF signal -RF and the image signal -Image with the local oscillation signal +LO and divide the RF signal -RF and the image signal -Image to different frequency bands. Thus, the image signal component separated to the negative (-) frequency band can be removed using a filter.

While only the high side injection is depicted in FIG. 4 by way of example, the low side injection can be realized in the same manner.

While the image is rejected using -RF, -Image, and +LO in FIG. 4 by way of example, the image rejection function can be fulfilled using +RF, +Image, and -LO in some cases.

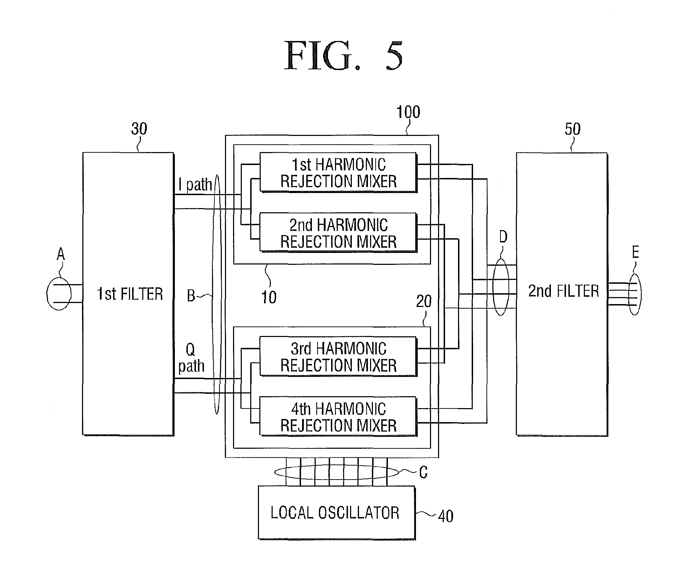

FIG. 5 is a block diagram of an RF receiver according to an exemplary embodiment.

The RF receiver of FIG. 5 includes a first filter 30, a mixer 100, a Local Oscillator (LO) 40, and a second filter 50. The RF receiver of FIG. 5 can be implemented using a wideband RF receiver.

The mixer 100 is in the same structure as the mixer 100 of FIGS. 1 through 4, which has been explained in FIGS. 1 through 4. Thus, the mixer 100 shall not be further described. To simplify the disclosure, it is assumed that the mixer 100 is implemented using the harmonic rejection mixer of FIG. 2A.

The first filter 30 converts the input RF signal In to the I/Q signals. In more detail, the first filter 30 divides the input RF+ signal InP and RF- signal InN to the in-phase signals InIP and InIN and the quadrature phase signals InQP and InQN. For example, the first filter 30 can be implemented using a Poly Phase Filter (PPF). The PPF can achieve the phase characteristics of the relatively wideband by virtue of the polyphase filter and does not easily generate the amplitude difference between the I/Q.

The first filter 30 may be implemented using a RC phase shifter and a frequency divider. The RC phase shifter makes use of the pass phase difference of the LPF and the HPF and can generate a quadrature signal having the 90° phase difference. The frequency divider can generate the divided outputs of the 90° phase difference when producing the 1/2 divided output of the input signal.

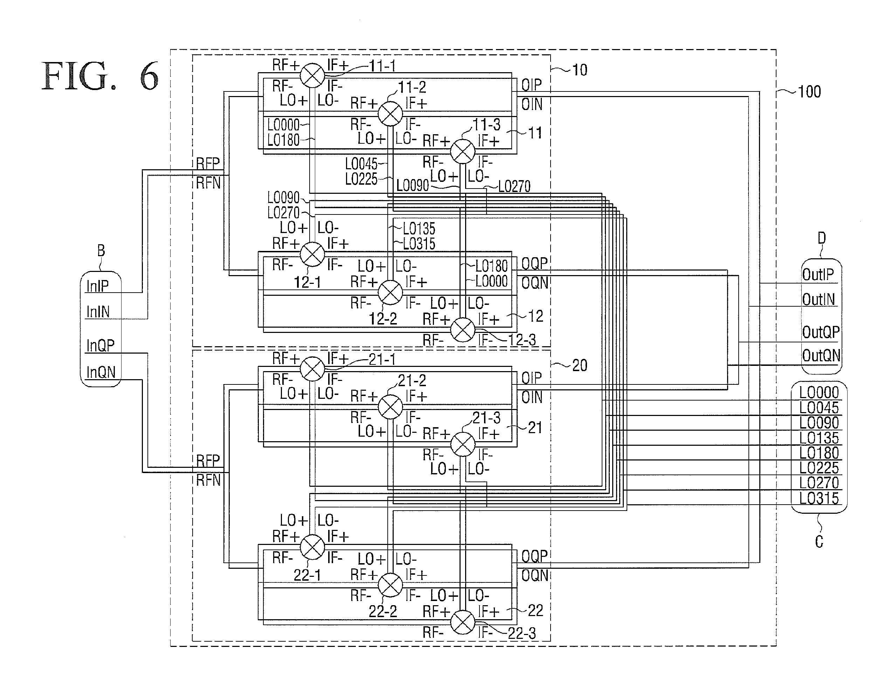

Accordingly, the signal output from the first filter 30 is divided to the in-phase path I_path which outputs the in-phase signals InIP and InIN and the quadrature phase path Q_path which outputs the quadrature phase signals InQP and InQN (FIG. 6). The mixer 100 converts the I/Q RF signal output from the first filter 30 to the I/Q IF signal (e.g., the center frequency 4 MHz). The mixer 100 down-converts the RF signal to the IF signal by mixing the local oscillation signal LO output from the LO 40. Herein, the center frequency indicates the frequency converted to demodulate in the RF reception scheme which converts the RF frequency to a lower frequency.

The in-phase signals InIP and InIN output from the first filter 30 along the in-phase path I_path are fed to the first harmonic rejecter 10, and the quadrature phase signals InQP and InQN output in the quadrature phase path Q_path are fed to the second harmonic rejecter 20.

The LO 40 supplies the local oscillation signal LO to the mixer 100 for the frequency synthesis.

A Phase Locked Loop (PLL), which is not shown, fixes the RF LO output frequency to a constant frequency without jitter. That is, the PLL can function to shift and fix the RF LO output frequency to the intended frequency by regulating the voltage of a Voltage Controlled Oscillator (VCO) used as the RF LO through the control input.

The first harmonic rejection mixer 11 of the first harmonic rejecter 10 can convert the input in-phase RF signals InIP and InIN to the in-phase IF signal by down-converting the in-phase RF signals using the in-phase local oscillation signal LO I. The second harmonic rejection mixer 12 can convert the in-phase RF signals InIP and InIN to the quadrature phase IF signal by down-converting using the quadrature phase local oscillation signal LO Q.

The third harmonic rejection mixer 21 of the second harmonic rejecter 20 can convert the input quadrature phase RF signals InQP and InQN to the in-phase IF signal by down-converting using the quadrature phase local oscillation signal LO Q. The fourth harmonic rejection mixer 22 can convert the quadrature phase RF signals InQP and InQN to the quadrature phase IF signal by down-converting using the in-phase local oscillation signal LO I.

The second filter 50 filters the image signal in the IF output of the mixer 100 which rejects the harmonic signal component and the image signal component. The second filter 50 can be implemented using a complex filter which minimizes the image signal Is and passes the real signal Rs in the IF signal output from the mixer 100. In some cases, the second filter 50 can be implemented using a polyphase filter.

FIG. 6 is a detailed circuit diagram of the mixer 100 according to an exemplary embodiment.

The mixer 100 of FIG. 6 includes the first harmonic rejecter 10 which receives the first input signals InIP and InIN, and the second harmonic rejecter 20 which receives the second input signals InQP and InQN.

Herein, the first input signals InIP and InIN include a first positive input signal InIP and a first negative input signal InIN having a phase difference of 180 degrees. The second input signals InQP and InQN include a second positive input signal InQP and a second negative input signal InQN having a phase difference of 180 degrees. The first input signals InIP and InIN have a phase difference of 90 degrees with the second input signals InQP and InQN.

The first harmonic rejecter 10 includes the first harmonic rejection mixer 11 and the second harmonic rejection mixer 12 which receive the first positive input signal InIP and the first negative input signal InIN.

The first harmonic rejection mixer 11 includes first, second and third local mixers 11-1, 11-2, and 11-3, and the second harmonic rejection mixer 12 includes first, second and third local mixers 12-1, 12-2, and 12-3.

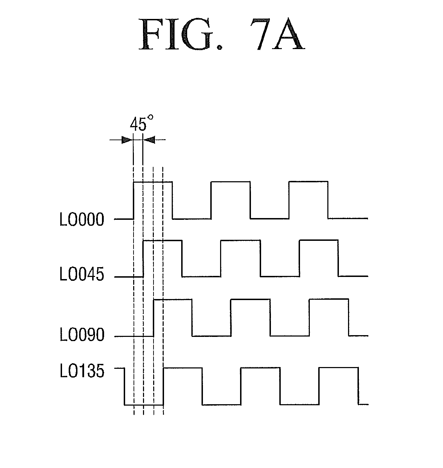

FIG. 7A illustrates a wave form of the local oscillation signal input to the mixer 100.

In FIG. 7A, the local oscillation signal LO includes four positive sub-local oscillation signals Φ1 + (LO00), Φ2+ (LO45), Φ3+ (LO90), and Φ4+ (LO135), and four negative sub-local oscillation signals Φ1- (LO180) Φ2- (LO225), Φ3-(LO270), and Φ4- (LO315).

The four positive sub-local oscillation signals Φ1+, Φ2+, Φ3+, and Φ4+ have a phase difference of 45 degrees with each other, and can correspond to LO00, LO45, LO90, and LO135 of FIG. 6 respectively.

The four negative sub-local oscillation signals Φ1-, Φ2-, Φ3-, and Φ4- have a phase difference of 45 degrees with each other, and can correspond to LO180, LO225, LO270, and LO315 of FIG. 6 respectively.

The four negative sub-local oscillation signals Φ1-, Φ2-, Φ3-, and Φ4- have a phase difference of 180 degrees with the four positive sub-local oscillation signals Φ1 +, Φ2+, Φ3+, and Φ4+. Namely, the local oscillation signal LO includes the eight signals having a phase difference of 45 degrees.

The first local mixer 11-1 receives the first positive sub-local oscillation signal Φ1+ and the first negative sub-local oscillation signal Φ1-, combines the first positive sub-local oscillation signal Φ1+ and the first negative sub-local oscillation signal Φ1- with the first input signals InIP (RF+) (or RFP) and InIN (RF-) (RFN), and outputs IF+ and IF- signals. Herein, the combining indicates the subtraction of the frequency of the input signals InIP and InIN and the frequency of the first positive sub-local oscillation signal Φ1+ and the first negative sub-local oscillation signal Φ1-.

The second local mixer 11-2 receives the second positive sub-local oscillation signal Φ2+ and the second negative sub-local oscillation signal Φ2-, combines the second positive sub-local oscillation signal Φ2+ and the second negative sub-local oscillation signal Φ2- with the first input signals InIP (RF+) and InIN (RF-), and outputs IF+ and IF- signals.

The third local mixer 11-3 receives the third positive sub-local oscillation signal Φ3+ and the third negative sub-local oscillation signal Φ3-, combines the third positive sub-local oscillation signal Φ3+ and the third negative sub-local oscillation signal Φ3- with the first input signals InIP (RF+) and InIN (RF-), and outputs IF+ and IF- signals.

That is, the first, second and third local mixers 11-1, 11-2 and 11-3 can be mixers of the double balanced structure, which each receives two RF signals RF+ and RF-, mixes the RF signals RF+ and RF- signals with the two LO signals LO+ and LO-, and outputs two IF signals IF+ and IF-.

The outputs of the first, second and third local mixers 11-1, 11-2 and 11-3 are connected in parallel and produce the output signals OIP and OIN. In other words, the first harmonic rejection mixer 11 can be a harmonic rejection mixer of the double balanced structure which receives two RF signals RF+ and RF-, mixes the two RF signals RF+ and RF- with six LO signals LO+ and LO- and outputs two IF signals OIP and OIN.

Similar to the first, second and third local mixers 11-1, 11-2 and 11-3, the fourth, fifth, and sixth local mixers 12-1, 12-2 and 12-3 combine the input signals InIP and InIN and the local oscillation signal LO and yield the output signals OQP and OQN.

More specifically, the fourth local mixer 12-1 receives the third positive sub-local oscillation signal Φ3+ (LO90) and the third negative sub-local oscillation signal Φ3-(LO270) having a phase difference of 90 degrees from the first positive sub-local oscillation signal Φ1+ (LO00) and the first negative sub-local oscillation signal Φ1-(LO180) output from the first local mixer 11-1, combines the third positive sub-local oscillation signal Φ3+ (LO90) and the third negative sub-local oscillation signal Φ3- (LO270) having a phase difference of 90 degrees from the first positive sub-local oscillation signal Φ1+ (LO00) and the first negative sub-local oscillation signal Φ1- (LO180) with the first input signals InIP and InIN.

The fifth local mixer 12-2 receives the fourth positive sub-local oscillation signal Φ4+ (LO135) and the fourth negative sub-local oscillation signal Φ4- (LO315) having a phase difference of 90 degrees from the second positive sub-local oscillation signal Φ2+ (LO45) and the second negative sub-local oscillation signal Φ2- (LO225) output from the second local mixer 11-2, combines the fourth positive sub-local oscillation signal Φ4+ (LO135) and the fourth negative sub-local oscillation signal Φ4- (LO315) having a phase difference of 90 degrees from the second positive sub-local oscillation signal Φ2+ (LO45) and the second negative sub-local oscillation signal Φ2- (LO225) with the first input signals InIP and InIN.

The sixth local mixer 12-3 receives the first negative sub-local oscillation signal Φ1-(LO180) and the first positive sub-local oscillation signal Φ1+ (LO00) having a phase difference of 90 degrees from the third positive sub-local oscillation signal Φ3+ (LO90) and the third negative sub-local oscillation signal Φ3- (LO270) output from the third local mixer 11-3, combines the first negative sub-local oscillation signal Φ1- (LO180) and the first positive sub-local oscillation signal Φ1+ (LO00) having a phase difference of 90 degrees from the third positive sub-local oscillation signal Φ3+ (LO90) and the third negative sub-local oscillation signal Φ3- (LO270) with the first input signals InIP and InIN.

That is, the fourth, fifth and sixth local mixers 12-1, 12-2 and 12-3 each can be a mixer of the double balanced structure which receives the two RF signals RF+ and RF-, mixes the two RF signals RF+ and RF- with the two LO signals LO+ and LO-, and outputs the two IF signals IF+ and IF-.

The outputs of the fourth, fifth and sixth local mixers 12-1, 12-2 and 12-3 are connected in parallel and yield the output signals OQP and OQN having a phase difference of 90 degrees with the output signals OIP and OIN of the first, second and third local mixers 11-1, 11-2 and 11-3. Namely, the second harmonic rejection mixer 12 also can be the harmonic rejection mixer of the double balanced structure which receives the two RF signals RF+ and RF-, mixes the two RF signals RF+ and RF- with the six LO signals LO+ and LO-, and outputs the two IF signals OIP and OIN.

In this case, the first harmonic rejecter 10 is of a single quadrature structure which receives the two RF signals RF+ and RF- and generates four IF signals OIP, OIN, OQP, and OQN.

As discussed earlier, when the local oscillation signal LO is divided into eight signals having the phase difference and fed to the first through sixth local mixers 11-1, 11-2, 11-3, 12-1, 12-2, and 12-3 of the first harmonic rejecter 10, this takes the same effect as in the case where the local oscillation signal LO is input to the first through sixth local mixers 11-1, 11-2, 11-3, 12-1, 12-2, and 12-3 in the quantized sinusoidal form. In so doing, it is possible to reject the harmonic signal having the integer multiple frequency of the frequency of the local oscillation signal LO from the IF output signal produced from the first harmonic rejecter 10. The second harmonic rejecter 20 includes the third harmonic rejection mixer 21 and the fourth harmonic rejection mixer 22 for receiving the second positive input signal InQP and the first negative input signal InQN.

The third harmonic rejection mixer 21 includes seventh, eighth, and ninth local mixers 21-1, 21-2 and 21-3, and the fourth harmonic rejection mixer 22 includes tenth, eleventh, and twelfth local mixers 22-1, 22-2 and 22-3.

The seventh, eighth, and ninth local mixers 21-1, 21-2 and 21-3 of the third harmonic rejection mixer 21 receive the same sub-local oscillation signals as the first, second and third local mixers 11-1, 11-2 and 11-3 of the first harmonic rejection mixer 11 and combine the sub-local oscillation signals of the first, second and third local mixers with the second input signals InQP and InQN.

The tenth, eleventh, and twelfth local mixers 22-1, 22-2 and 22-3 of the fourth harmonic rejection mixer 22 receive the same sub-local oscillation signals as the fourth, fifth and sixth local mixers 12-1, 12-2 and 12-3 of the second harmonic rejection mixer 12 and combine the sub-local oscillation signals of the fourth, fifth and sixth local mixers with the second input signals InQP and InQN.

For example, the seventh local mixer 21-1 receives the first positive sub-local oscillation signal Φ1+ (LO00) and the first negative sub-local oscillation signal Φ1-(LO180) provided from the first local mixer 11-1 and combines with the second input signals InQP and InQN.

Thus, the second harmonic rejecter 20 also attains the same harmonic rejection effect as the first harmonic rejecter 10.

Herein, the seventh through twelfth mixers 21-1, 21-2, 21-3, 22-1, 22-2 and 22-3 also output the down-converted IF signal of the RF signal.

The structures and characteristics of the second harmonic rejecter 20, the third harmonic rejection mixer 21, the fourth harmonic rejection mixer 22, and the seventh through twelfth mixers 21-1, 21-2, 21-3, 22-1, 22-2 and 22-3 are substantially the same as the structures and the characteristics of the first harmonic rejecter 10, the first harmonic rejection mixer 11, the second harmonic rejection mixer 12, and the first through sixth local mixers 11-1, 11-2, 11-3, 12-1, 12-2 and 12-3, and thus shall not be further explained.

The outputs OIP and OIN of the first harmonic rejection mixer 11 are combined with the outputs OQP and OQN of the fourth harmonic rejection mixer 22 and output as OutIP and OutIN.

The outputs OQP and OQN of the second harmonic rejection mixer 12 are combined with the outputs OIP and OIN of the third harmonic rejection mixer 21 and output as OutQP and OutQN.

That is, the mixer 100 is the double quadrature structure which receives and mixes the four RF signals InIP, InIN, InQP, and InQN with the eight local oscillation signals and provides the four IF signals OutIP, OutIN, OutQP and OutQN.

The output of the first harmonic rejecter 10 including the first harmonic rejection mixer 11 and the second harmonic rejection mixer 12 is connected with the output of the second harmonic rejecter 20 including the third harmonic rejection mixer 21 and the fourth harmonic rejection mixer 22 in parallel, and thus the image rejection function can be achieved at the same time.

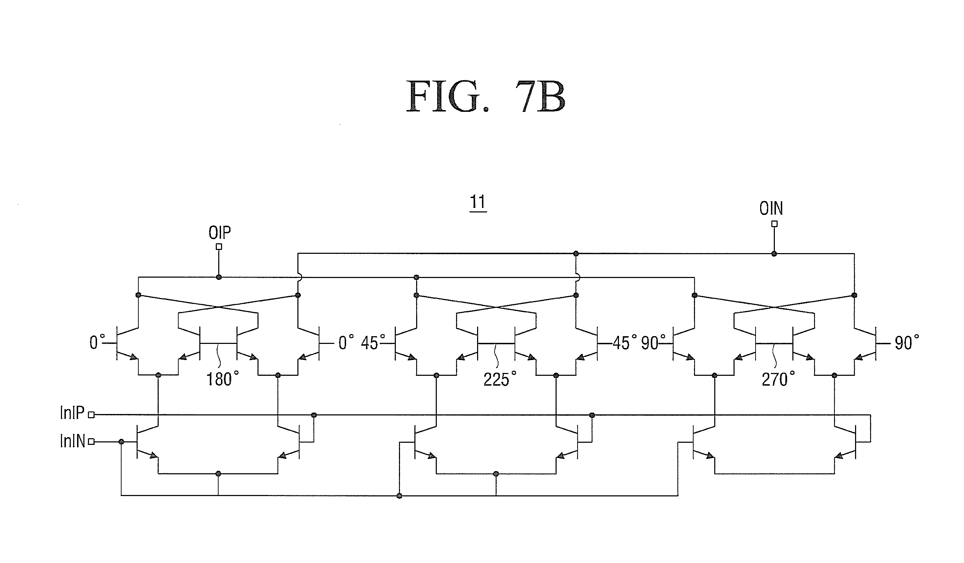

FIG. 7B is a circuit diagram of the harmonic rejection mixer according to an exemplary embodiment.

The construction of FIG. 7B can correspond to the first harmonic rejection mixer 11 of FIG. 6.

In FIG. 7B, the first, second and third local mixers 11-1, 11-2 and 11-3 include transistors TR1 through TR12 which are turned on or off in response to the local oscillation signal LO. As the local oscillation signal LO includes six signals having the phase difference and the six signals are applied to the corresponding transistors TR1 through TR12, the transistors TR1 through TR12 are turned on or off in sequence. As a result, the harmonic signal in the input RF signal is rejected.

While the structures of the second, third and fourth harmonic rejection mixers 12, 21 and 22 can be similar to the circuit of FIG. 7B, there can be a difference in the phase difference of the local oscillation signal LO supplied to the mixing, which has been described in detail by referring to FIG. 6 and shall be omitted here.

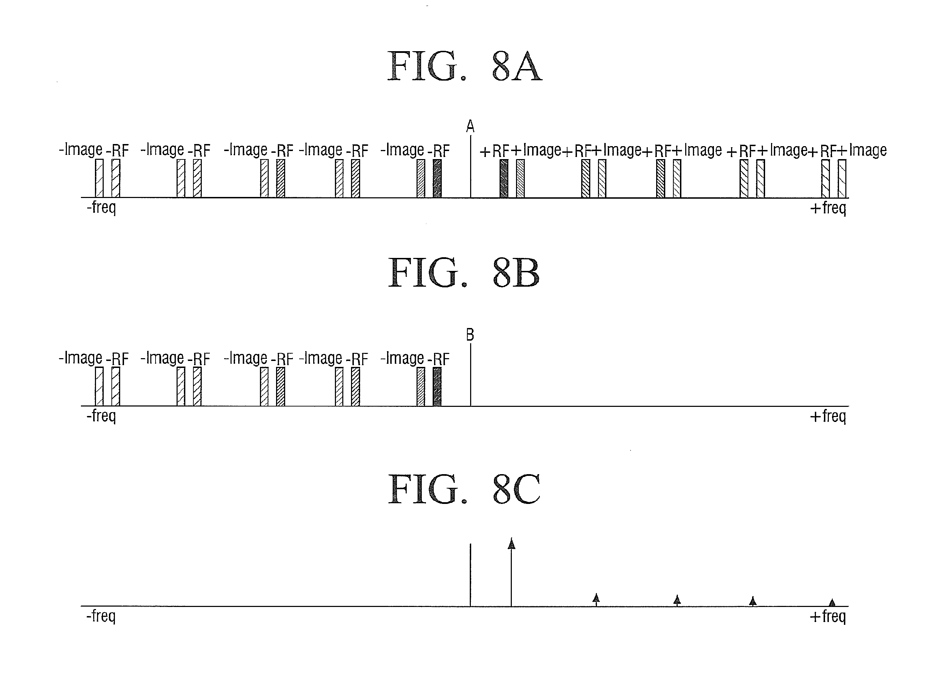

FIGS. 8A through 8E depict the signal form in each step of the structures of FIG. 5 and FIG. 6.

FIG. 8A shows the form of the signal A input to the first filter 30.

The signal input to the first filter 30 in FIG. 8A includes other frequency band signals RF+ and RF- than the signals of the intended frequency band. Each RF signal can include the image signal component; that is, the frequency Image+ and Image- symmetric to the RF signal based on the local oscillation frequency.

FIG. 8B shows the signal form B filtered through the first filter 30 and fed to the mixer 100. Substantially, the first filter 30 divides the input RF signals RF+ and RF- to the in-phase signals IRF+ and IRF- and the quadrature phase signals QRF+ and QRF-. This signal division is symbolically represented in the frequency axis as the signals in the positive frequency band (+freq) band are rejected in the paths according to the output of the first filter 30.

FIG. 8C shows the effect of the local oscillation signal LO input from the LO 40 to the mixer 100.

To simplify the explanations on the principles of the exemplary embodiments, the harmonic rejection and image rejection function of the harmonic and image rejection mixer is represented as the LO effect of the local oscillation signal.

Since the local oscillation signal LO is input as the plurality of the LO signals having the phase difference, it can be the quantized sinusoidal form as shown in FIG. 8C. On account of the double quadrature structure, the local oscillation signal LO can exist only in the +freq band.

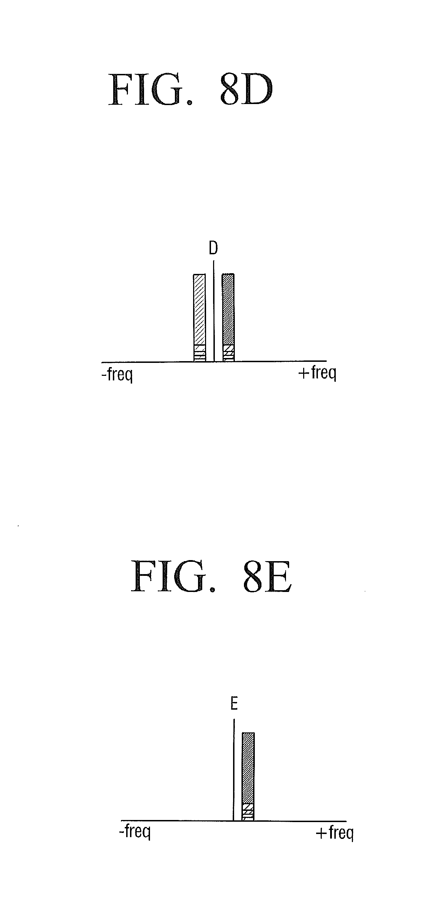

FIG. 8D shows the form D of the signal output from the mixer 100 and input to the second filter 50.

The mixer 100 mixes the in-phase signals IRF+ and IRF- and the quadrature phase signals QRF+ and QRF- input from the first filter 30 and the plurality of the local oscillation signals LO having the phase difference output from the LO 40. Thus, the output signal from the mixer 100 is free from the harmonic signal component as shown in FIG. 8D, and the RF signal and the image signal can be divided to the positive frequency band and the negative frequency band.

FIG.8E shows the form E of the signal output from the second filter 50.

In the signal output from the second filter 50 in FIG. 8E, the RF signal and the image signal output from the mixer 100 are divided to the positive frequency band and the negative frequency band. Next, the filtering rejects the image frequency in the negative frequency band.

As set forth above, the wideband RF receiver can reject the harmonic signal and image signal components at the same time without using an external element such as SAW filter. Therefore, in the current trend toward the integration to the RFIC or the SoC, the full integration wideband RF receiver excluding the use of the external element can be realized.

The foregoing exemplary embodiments and advantages are merely exemplary and are not to be construed as limiting the exemplary embodiments. The present teaching can be readily applied to other types of apparatuses. Also, the description of the exemplary embodiments are intended to be illustrative, and not to limit the scope of the claims, and many alternatives, modifications, and variations will be apparent to those skilled in the art.

## Claims

1. A mixer comprising:
a first harmonic rejecter which rejects a harmonic signal component from a first input signal; and
a second harmonic rejecter which rejects a harmonic signal component from a second input signal,
wherein the first harmonic rejecter and the second harmonic rejecter are connected in parallel to reject an image signal component from the first input signal and the second input signal.

2. The mixer of claim 1, wherein at least one of the first and second harmonic rejecters is implemented using a harmonic rejection mixer which rejects the harmonic signal component by mixing a plurality of local oscillation signals having a phase difference with the first input signal and the second input signal.

3. The mixer of claim 2, wherein the harmonic rejection mixer is in a single quadrature structure comprising two harmonic rejection mixers of a double balanced structure.

4. The mixer of claim 1, wherein at least one of the first harmonic rejecter and second harmonic rejecter is implemented using a harmonic rejection filter which filters the harmonic signal component in the first input signal and the second input signal, and a mixer which frequency-converts the filtered signal.

5. The mixer of claim 1, wherein the first harmonic rejecter receives an in-phase signal, the second harmonic rejecter receives a quadrature phase signal, and outputs of the first harmonic rejecter and the second harmonic rejecter are connected in parallel.

6. A Radio Frequency (RF) receiver comprising:
a first filter which filters an input signal; and
a mixer comprising a plurality of harmonic rejecters connected in parallel which reject a harmonic signal of the filtered input signal, and which reject an image signal component.

7. The RF receiver of claim 6, wherein the mixer comprises a first harmonic rejecter and a second harmonic rejecter connected to the first harmonic rejecter in parallel.

8. The RF receiver of claim 7, further comprising:
a local oscillator which generates a plurality of local oscillation signals having a phase difference,
wherein at least one of the first and second harmonic rejecters is implemented using a harmonic rejection mixer which rejects the harmonic signal component by mixing the plurality of the local oscillation signals having the phase difference with the filtered signal.

9. The RF receiver of claim 8, wherein the harmonic rejection mixer is in a single quadrature structure comprising two harmonic rejection mixers of a double balanced structure.

10. The RF receiver of claim 7, wherein at least one of the first harmonic rejecter and the second harmonic rejecter is implemented using a harmonic rejection filter which filters the harmonic signal, and a mixer which frequency-converts the filtered signal.

11. The RF receiver of claim 6, wherein the first filter is implemented using a polyphase filter which generates an in-phase signal and a quadrature phase signal with respect to the input signal.

12. The RF receiver of claim 6, further comprising:
a second filter disposed at a rear end of the mixer which filters the image signal component.

13. The RF receiver of claim 12, wherein the second filter is implemented using a complex filter.

14. The RF receiver of claim 12, wherein the second filter is implemented using a polyphase filter.

15. The RF receiver of claim 7, wherein the first harmonic rejecter receives an in-phase signal, the second harmonic rejecter receives a quadrature phase signal, and outputs of the first and second harmonic rejecters are connected in parallel.
